# EUROPEAN PATENT APPLICATION

(11) **EP 2 671 840 A2**
(43) Date of publication of application: **11.12.2013**
(21) Application number: 13167387.3
(22) Date of filing: 10.05.2013
(51) Int. Cl.: B81B 7/00

(54) **Systems and methods for particle contaminant entrapment**

(30) Priority: 06.06.2012 US 201213490071
(71) Applicant: Honeywell International Inc., Morristown, NJ 07962-2245 (US)
(72) Inventor: Roehnelt, Ryan, Morristown, NJ New Jersey 07962-2245 (US)
(74) Representative: Houghton, Mark Phillip

(57) **Abstract**

Systems and methods for particle contaminant entrapment are provided. In one embodiment, a sensor device comprises a sensor mechanism; a structure having an internal cavity housing at least one passive element of the sensor mechanism; and a particle contaminant getter within the cavity.

## Description

### BACKGROUND

It is sometimes difficult to clean and remove all undesirable stray metallic and non-metallic particles from packaged or sealed devices during the production of such devices. The physical structure of the device may cause the stray particles to initially catch and remain in crevices or hidden regions and later dislodge to interfere with operation of the device. This is especially true of machined parts with intricate details where the machining process itself can produce particle contaminants in the form of chips. This can also occur when the device in operation is subjected to vibration, shock, stress, and/or aging that cause additional particles to slough off inside the packaged product.

For the reasons stated above and for other reasons stated below which will become apparent to those skilled in the art upon reading and understanding the specification, there is a need in the art for improved systems and methods for particle contaminant entrapment.

### SUMMARY

The Embodiments of the present invention provide methods and systems for particle contaminant entrapment and will be understood by reading and studying the following specification. In one embodiment, a sensor device comprises a sensor mechanism; a structure having an internal cavity housing at least one passive element of the sensor mechanism; and a particle contaminant getter within the cavity.

### DRAWINGS

The following exemplary figures are intended to aid the understanding of the written description of the exemplary embodiments and should not be considered limiting in scope.

Figures 1 and 1A are cross sectional diagrams of a device having a particle contaminant getter of one embodiment of the present invention;

Figure 2 is a cross sectional diagram of a device having a particle contaminant getter of one embodiment of the present invention;

Figure 3 is a cross sectional diagram of a device having a particle contaminant getter of one embodiment of the present invention;

Figure 3A is a cross sectional diagram of a device having a particle contaminant getter of one embodiment of the present invention;

Figure 4 is a block diagram of a system with a device having a particle contaminant getter of one embodiment of the present invention; and

Figure 5 is a flow chart illustrating a method of one embodiment of the present invention.

In accordance with common practice, the various displayed features are not necessarily drawn to scale but are drawn to emphasize specific features relevant to the exemplary embodiments.

### DETAILED DESCRIPTION

In the following description, reference is made to the accompanying drawings and specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed. The following description is, therefore, not to be taken in a limiting sense.

Embodiments of the present invention provide for devices with internal particle getters that capture particle contaminants and prevent them from interfering with the operation of electrical and mechanical components within the device. As used herein, the term "particle contaminant" is used to refer to small pieces of solid matter materials as distinguished from gas particles or other atomic or sub-atomic scale particles. Loose particle contaminants, if allowed to come in contact with the electrical and mechanical components, can potentially cause an electrical short in an electrical mechanism, or impede movement of a mechanical mechanism.

As an example, a flexure-type accelerometer is a device, typically on the order of 1 inch across in diameter, that comprises small electrical-mechanical features having thin-gap clearances (such as in the range of 5-50 microns, for example). For example, the flexure-type accelerometer may include a pair of capacitor plates having a mechanical standoff from each other in this range. One capacitor plate is held mechanically static while the other capacitor plate forms part of a paddle that moves (or at least has the potential to move) due to vibrations, accelerations or mechanical shock. If a particle contaminant is permitted to enter this area of the device, it can cause a short between the capacitor plates or form a mechanical blockage which would result in an output from the device that has measurements errors.

Embodiments of the present invention address these problems by including a particle contaminant getter within one or more internal cavities of a device where particle contaminants may collect or be generated. In one embodiment, a dual phase getter scheme utilizes a getter material that starts in a liquid phase and then cures (either with time, UV activated curing, a catalyzed reaction, an applied heating, or by other means, for example) into a gel type getter material coating. While a liquid, the getter material is injected into an internal cavity that contains passive elements (that is, elements of the device that will not be affected by contact with the getter material). The getter material while in liquid form is distributed about the cavity, as described below, to capture any loose particle contaminants. As the getter material then cures from the liquid phase to a gel, those captured particle contaminants become embedded within the getter material such that they are no longer free to move about. In gel form, the getter material forms a coating on internal surfaces within the cavity that remains tacky, having an adhesive surface that continues to collect any other loose particle contaminants that come into contact with the adhesive surface.

In another embodiment, a preformed strip of getter material in gel form is applied within the cavity during device fabrication. While the preformed strip of getter material in gel form cannot be distributed to collect loose particle contaminants as a liquid phase getter material can, it will still have an adhesive surface that collects any loose particle contaminants within the cavity that come into contact with the adhesive surface. Further, the preformed strip of getter material embodiment may be useful where the cavity does include more than just passive elements, such as elements whose operation will be affected if coated with the getter material. In any of the embodiments described herein, the getter material may be a silicone material, or other material that remains tacky after curing.

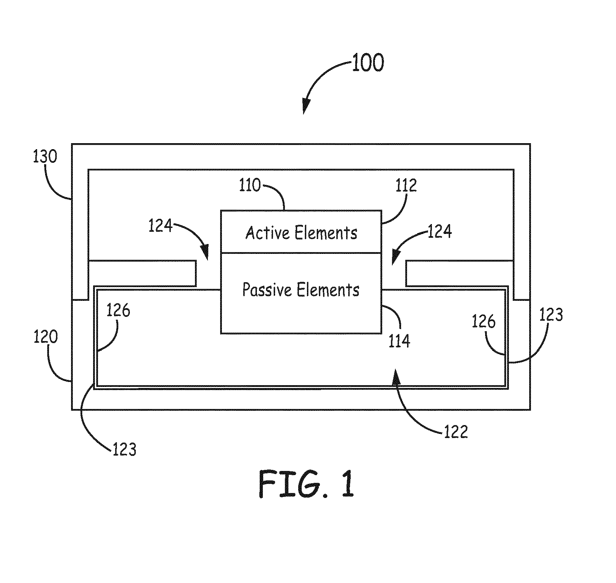

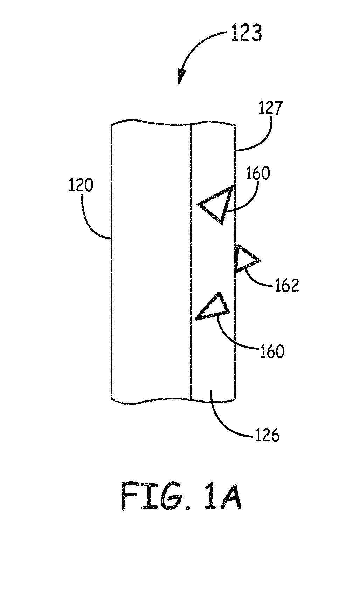

Figure 1 is a simplified diagram of a device 100 of one embodiment of the present invention. In one embodiment, device 100 is a sensing device, such as, but not limited to a flexure-type accelerometer such as the Honeywell Q-flex® accelerometer. Device 100 includes a sensor mechanism 110 that includes active elements 112 and passive elements 114. As used herein, the term "active elements" refers to either exposed electrically conducting or charged components (such as exposed capacitive elements, for example) or mechanical components that require a freedom of motion to properly operate (such as any moving or rotating elements, for example). Conversely, the term "passive elements" refers to electrical elements without exposed electrically conducting or charged components, or static mechanical components. Examples of a passive element would be magnetic circuit elements that carry magnetic flux currents, or an insulated electrical coil around an iron core.

In the embodiment of Figure 1, at least part of the passive elements 114 are housed within a structure 120 having an internal cavity 122. The active elements 112 may be enclosed by a cover 130 that is sealed onto structure 120 (for example, by welding, threads, latches, bands, or other means). At least one path 124 connects internal cavity 122 housing passive elements 114 with the active elements 112. Accordingly, any loose particle contaminants that exist or form within internal cavity 122 have the potential to travel through path 124 and become lodged or otherwise come into contact with active elements 112 in such a way as to interfere with their operation.

Accordingly, device 100 is equipped with a particle contaminant getter 126 located within internal cavity 122. In one embodiment, a particle contaminant getter 126 is a dual phase getter where the getter material used starts in a liquid phase and then cures into a gel type getter material coating. In the embodiment shown in Figure 1, the getter material is a silicone material. In other embodiments, other materials may be used. While in liquid phase, the getter material is injected or otherwise dropped into internal cavity 122. Device 100 is manipulated to spread the getter material around and across the internal surfaces within internal cavity 122, capturing any loose particles within internal cavity 122. In one embodiment, device 100 is spun to coat up the cavity wall surfaces (shown at 123) with the liquid getter material. Control of the orientation and rotational velocity of the spinning may be used to control the distribution of the liquid getter material which determines which surfaces within internal cavity 122 get coated.

Loose particle contaminants within internal cavity 122 that come into contact with the liquid getter material are collected and captured by the getter material. The liquid getter material then cures in place into a gel to form particle contaminant getter 126. As illustrated in Figure 1A, particle contaminants 160 collected by the liquid getter material, after curing, become embedded with the particle contaminant getter 126 where they will remain for the life of device 100. Once cured into a gel phase, particle contaminant getter 126 will possess an adhesive surface 127 that continues to collect additional loose particle contaminants 162 for the life of device 100. As a result, particle contaminants 160 embedded within particle contaminant getter 126, and particle contaminants 162 that become adhered to adhesive surface 127 of particle contaminant getter 126 are no longer available to travel through path 124 or obstruct operation of active elements 112.

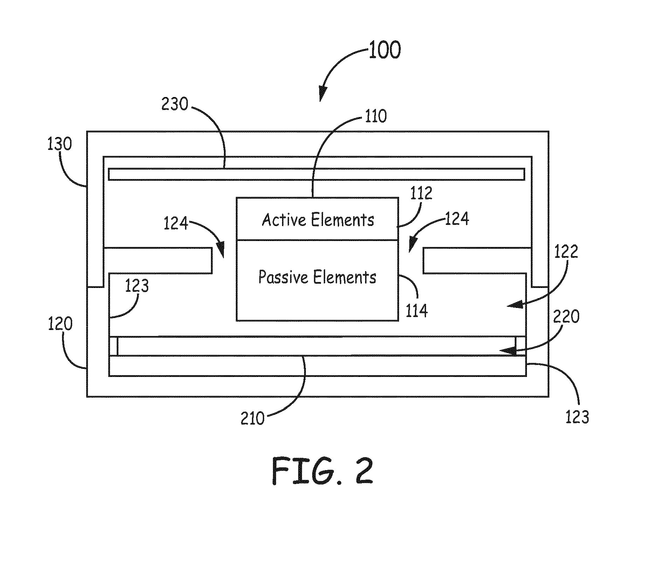

Figure 2 is a simplified diagram of device 100 utilizing a preformed particle contaminant getter 210 within cavity 122. In alternate embodiments, preformed particle contaminant getter 210 may be used in device 100 either instead of, or in addition to the dual phase particle contaminant getter 126 scheme described with respect to Figure 1. In the embodiment shown in Figure 2, preformed particle contaminant getter 210 is adhered to cavity wall surface 123 and includes an adhesive surface 220 exposed to the interior space of internal cavity 122 that collects any loose particle contaminants within that come into contact with the adhesive surface 220. Further, in some embodiments, device 100 may optionally utilize dual phase particle contaminant getter 126 scheme described with respect to Figure 1 within internal cavity 122 and a preformed particle contaminant getter 230 in the region housing active components 110.

The preformed particle contaminant getters 210, 230 may be formed from a malleable strip and made to conform to a shape that will adhere to a surface within cavity 122. In one embodiment, the strip is coated with the tacky getter material. In some implementations, the preformed particle contaminant getters 210, 210 can each be applied as multiple individual pieces that are mounted in different regions. Particle contaminants can then be trapped in various regions inside device 100, regardless how it is oriented or turned on its side.

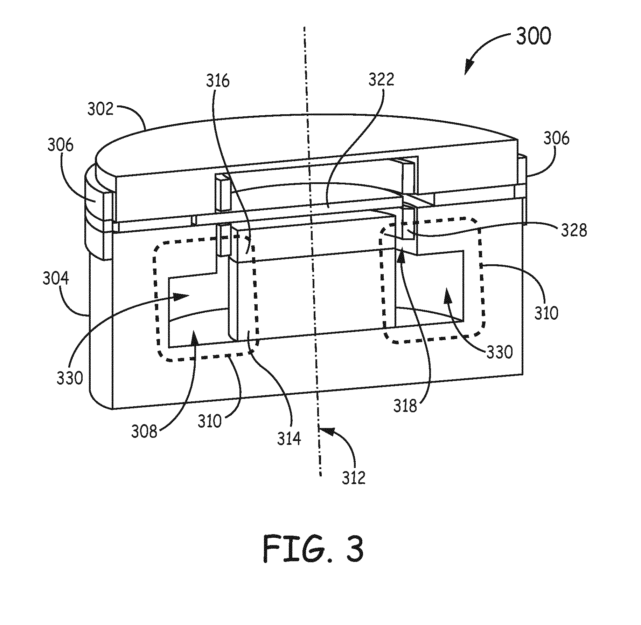

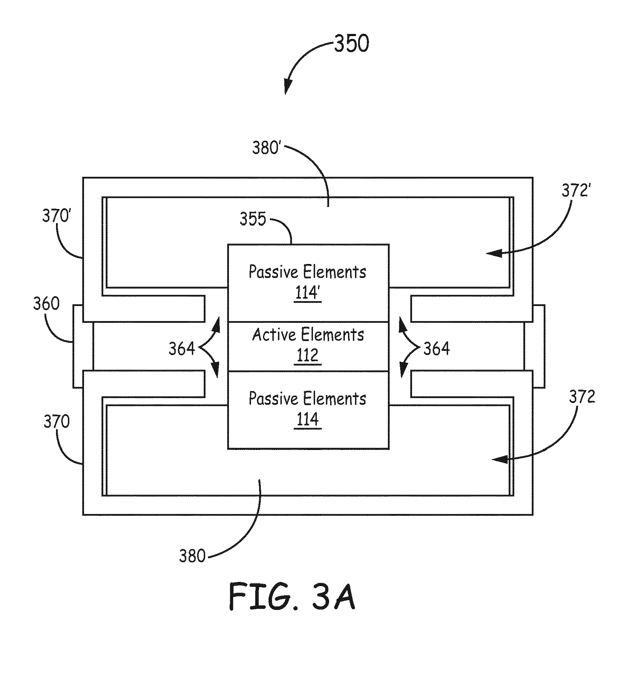

Figure 3 is a diagram of a flexure-type accelerometer 300 of an embodiment of the present invention having a particle contaminant getter such as described above. In one embodiment, accelerometer 300 is flexure-type accelerometer such as the Honeywell Q-flex® accelerometer. In one implementation, the particular accelerometer 300 shown in Figure 3 is on the order of 1 inch in diameter and about 0.5 inch in height. However, these dimensions are provided for illustrative purposes only.

Accelerometer 300 comprises a stator 302 coupled to a excitation ring 304 using a band 306. Excitation ring 304 is a structure that includes a toroidal shaped internal cavity 308 that is defined by the inner walls of the excitation ring 304. Excitation ring 304 further includes a magnet 314 within internal cavity 308 which in conjunction with coil 328 generates a magnetic circuit through excitation ring 304 and pole piece 316 when in operation, as illustrated by flux 310. For the reasons described above, these devices exposed within internal cavity 308 are described as passive elements. The stator 302 houses a proof mass paddle 322 which rotates and/or is displaced relative to the excitation ring 304 when the accelerometer 300 is accelerated in some direction or in an oscillatory manner. As such, proof mass paddle 322 for the reasons described above, is described as an active elements. Although pole piece 316 and coil 328 block ready access for larger loose particle contaminants in cavity 308 from reaching proof mass paddle 322, finer particle contaminants may travel through one or more air-space gaps (such as shown at 318) that form connecting paths. If not captured, particle contaminants such as machining chips or other particles trapped in accelerometer during manufacturing or assembly, or due to sloughing later on, may block the paddle 322 from moving properly and conductive particle contaminants can cause electrical shorts. Additionally, conductive particles could induce small electromagnetic fields that alter the normal, intended operational value of the field 310.

To reduce the possibility of these problems, accelerometer 300 comprises a dual phase particle contaminant getter 330 applied as a getter material coating within internal cavity 308. Particle contaminant getter 330 comprises a tacky film or substance, such a silicone material that coats one or more exposed surfaces within excitation ring 304 near which particle contaminants exist or to which they may travel. When the undesirable particles contact the getter material, they stick to the material and remain in the material or on the surface of the material. This trapping mechanism reduces the amount of undesirable particles that may otherwise be freely moving about inside accelerometer 300. The particular getter material selected should have an adhesiveness that will keep the particle contaminants entrapped based on the size and weight of expected particle contaminants.

In one embodiment, when the getter material for particle contaminant getter 330 is in the form of a relatively-low viscosity liquid substance, it is injected into cavity 308 and distributed in such a manner that avoids the liquid oozing out of cavity 308 or undesirably coating other pieces of the accelerometer. For example, a needle or similar dispenser may be used to feed the liquid getter material through gap 318 into internal cavity 308. In one embodiment the assembled unit is spun around its central axis 312 in order that the liquid getter material spreads around cavity 308, traveling upward and coating the inner wall of the cavity 308. The rotational speed and duration of speed determine the degree to which the interior of the cavity 308 is coated to and to what height. The spinning may leave a pattern on the inner wall where the liquid may be a little thicker on the upper ends than near the bottom of the wall, or there may be a swirl pattern, depending on the speed of rotation. That is, spinning may leave some physical pattern in the resulting getter material coating that is different from coating the surface through painting or some other mechanism. This spinning also serves to collect loose particle contaminants within 308 which will become encased as the liquid getter material cures to a gel coating. The curing of the getter material may be a function of time, or may be accomplished by thermal curing or a catalyzed curing in order to turn the liquid into a gel. In the catalyst method, the first injection is the tacky liquid that could be some type of resin. In the case of a catalyzed curing, a second optional injection of a catalyzing chemical may be performed and the chemical distributed in the same manner as the liquid getter material.

Figure 3A provides another alternate embodiment of a device 350 of one embodiment of the present invention. In one embodiment, device 350 is a sensing device, such as, but not limited to a flexure-type accelerometer. Device 350 includes a sensor mechanism 355 that includes active elements 112 and two sets passive elements shown as 114 and 114'. One example of such an embodiment is an accelerometer, such as one similar to accelerometer 300, that has both upper and lower excitation rings with the active elements (i.e., proof mass paddle 322) in the middle. That is, device 350 includes a first structure 370 with passive elements 114 housed within an internal cavity 372, and a second structure 370' with passive elements 114' housed within an internal cavity 372'. The active elements 112 may be enclosed in a housing 360 that is sealed together with structures 370 and 370' (for example, by welding, threads, latches, bands, or other means). Path 364 exist within device 350 that connect internal cavities 372 and 372' housing passive elements 114 and 114' with the active elements 112. Accordingly, any loose particle contaminants that exist or form within internal cavities 372 or 372' have the potential to travel through paths 364 and become lodged or otherwise come into contact with active elements 112 in such a way as to interfere with their operation. In this embodiment, particle contaminant getters 380 and 380' function in the same manner as any of the particle contaminant getters 126, 210 0r 330 described above to capture particle contaminants that may exists within the cavities 370 and 370', to prevent the particle contaminants from interfering with either the electrical or mechanical operation of the active elements 112.

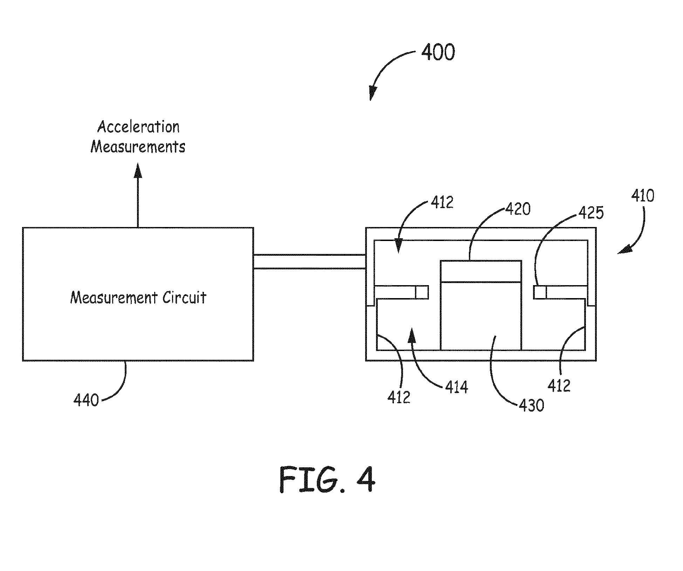

Figure 4 is a diagram illustrating a system 400 having a sensor device 410 that includes a particle contaminant getter 412 of one embodiment of the present invention. In alternate embodiments, system 400 may be realized utilizing any of the embodiments of device 100 or accelerometer 300 described above. In one embodiment, sensor device 410 comprises capacitive elements 420 within a first region 412 of sensor device 410, and a magnetic circuit 430 within a second region 414 of sensor device 410. In operation, a measurement circuit 440 is coupled to sensor device 410 that supplies a current to coil 425, which operates magnetic circuit 430. Measurement circuit 440 controls coil 425 to attempt to maintain capacitive elements 420 in a capacitively balanced position with respect to each other as indicated by a current feedback. The amount of current required to keep capacitive elements 420 in a capacitively balanced position provides an indication of accelerations. That is, measurement circuit 440 measures the current needed to power coil 425 sufficiently to counter the accelerations, and outputs an acceleration measurement based on that current. Particle contaminant getter 412 comprises any one of the getters 126, 210, 230 or 330 described above to capture particle contaminants that may exists within the second region 414, to prevent them from interfering with either the electrical or mechanical operation of the capacitive elements 420 within first region 412.

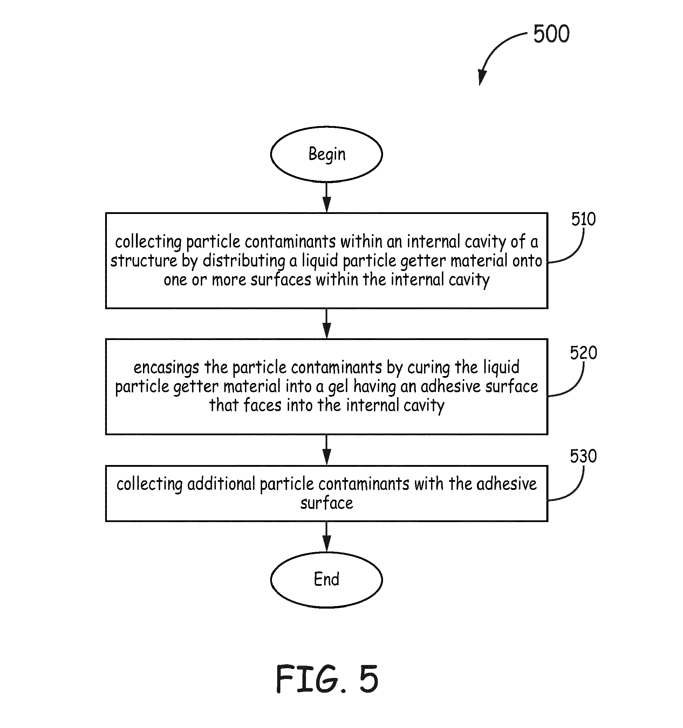

Figure 5 is a flow chart illustrating a method 500 of one embodiment of the present invention. In alternate embodiments, method 500 may be implemented in conjunction with any of the embodiments of device 100, accelerometer 300 or system 400 described above. In other embodiments method 500 may be implemented in conjunction with other devices and systems.

The method begins at 510 with collecting particle contaminants within an internal cavity of a structure by distributing a liquid particle getter material onto one or more surfaces within the internal cavity. In one implementation, the liquid particle getter material may comprise silicone. In one embodiment, the liquid particle getter material is injected into an internal cavity that contains passive elements. The getter material while in liquid form is distributed about the cavity to capture any loose particle contaminants. In one embodiment, the structure is spun to coat the cavity wall surfaces with the liquid getter material. Control of the orientation and rotational velocity of the spinning may be used to control the distribution of the liquid getter material. This will determine which surfaces within the internal cavity get coated.

The method proceeds to 520 with encasings the particle contaminants by curing the liquid particle getter material into a gel having an adhesive surface that faces into the internal cavity. As the getter material then cures from the liquid phase to a gel, the captured particle contaminants become embedded within the getter material such that they are no longer free to move about. In gel form, the getter material forms a coating on internal surfaces within the cavity that remains tacky, having an adhesive surface that continues to collect any other loose particle contaminants that come into contact with the adhesive surface. As such, in some embodiments, the method may continue with collecting additional particle contaminants with the adhesive surface (at block 530). In some embodiments, the method may further include placing additional preformed particle contaminant getters within the internal cavity. Additional preformed particle contaminant getters may also be placed outside of the cavity, such as in the vicinity of one or more active components.

### Example Embodiments

Example 1 includes a sensor device, the device comprising: a sensor mechanism; a structure having an internal cavity housing at least one passive element of the sensor mechanism; a particle contaminant getter within the cavity.

Example 2 includes the device of example 1, wherein the particle contaminant getter comprises a getter material coating cured to one or more surfaces of the internal cavity.

Example 3 includes the device of any of examples 1-2, wherein the getter material coating comprises an adhesive surface exposed to an interior space of the internal cavity.

Example 4 includes the device of any of examples 1-3, wherein the getter material coating comprises a cured silicone material.

Example 5 includes the device of any of examples 1-4, wherein the getter material coating encases one or more contaminant particles.

Example 6 includes the device of any of examples 1-5, wherein the sensor mechanism further includes at least one active element not located within the internal cavity, wherein the sensor device further comprises a path between the internal cavity and the active element.

Example 7 includes the device of any of examples 1-6, wherein one or both of the body and the passive element comprises a metal core magnetic circuit.

Example 8 includes the device of any of examples 1-7, wherein one or both of the body and the passive element comprises at least part of an accelerometer excitation ring.

Example 9 includes the device of any of examples 1-8, wherein the active element comprises a pair of capacitive plates.

Example 10 includes the device of any of examples 1-9, wherein the active element comprises a mechanical mechanism.

Example 11 includes the device of any of examples 1-10, wherein the particle contaminant getter comprises a preformed strip of getter material adhered to a surface within the inner cavity.

Example 12 includes a method for providing a particle contaminant getter for a device, the method comprising: collecting particle contaminants within an internal cavity of a structure by distributing a liquid particle getter material onto one or more surfaces within the internal cavity; and encasings the loose particle contaminants by curing the liquid particle getter material into a gel having an adhesive surface that faces into the internal cavity.

Example 13 includes the method of example 12, further comprising collecting additional particle contaminants with the adhesive surface.

Example 14 includes the method of any of examples 12-13, wherein the liquid particle getter material is a silicone material.

Example 15 includes the method of any of examples 12-14, wherein distributing the liquid particle getter material onto one or more surfaces within the internal cavity further comprises: spinning the structure.

Example 16 includes the method of any of examples 12-15, further comprising: forming a getter material coating on the one or more surfaces within the internal cavity by curing the liquid getter material.

Example 17 includes the method of any of examples 12-16, the device includes at least one active element not located within the internal cavity, wherein the device further comprises a path between the internal cavity and the at least one active element.

Example 18 includes the method of any of examples 12-17, wherein the device is any of the devices of Examples 1-11.

Example 19 includes a sensor system, the system comprising: a sensor device comprising one or more active elements within a first region and one or more passive elements within a second region; and a measurement circuit coupled to the sensor device, wherein the measurement circuit supplies a current to a coil which operates the magnetic circuit; wherein the sensor device further includes a particle contaminant getter within the second region.

Example 20 includes the sensor system of examples 19, wherein the one or more active elements comprise capacitive elements and the one or more passive elements include a magnetic circuit.

Example 21 includes the sensor system of any of examples 19-20, wherein the particle contaminant getter comprises a getter material coating distributed onto one or more surfaces within the second region.

Example 22 includes the sensor system of any of examples 19-21, wherein the sensor device is any of the devices of Examples 1-11.

The orientation and directions stated and illustrated in this application should not be taken as limiting. For example, the directions, e.g. "top," are merely illustrative and do not orient the embodiments absolutely. That is, a structure formed on its "side" or "bottom" is merely an arbitrary orientation in space that has no absolute direction. Also, in actual usage, an accelerometer may well be turned on its "side" because, for example, aircrafts and vehicles travel and turn in all directions. Thus, the stated directions in this application are arbitrary designations. In addition, accelerometers are normally used in triads where three accelerometer sensors are oriented to sense in directions mutually orthogonal with respect to each other. In system where redundancy is desired, more than three accelerometers may be used to compensate for sensor failures without affecting performance.

For any of the embodiment described herein, the particular getter material selected should have an adhesiveness that will keep the particle contaminants entrapped based on the size and weight of expected particle contaminants. For applications such as an accelerometer having a magnet, an electrically and magnetically neutral getter material should be considered. Further, depending on the application, selecting a getter material with minimal out-gassing may be desired. Also, although some of the above embodiments of a particle getter are described in the context of a flexure-type accelerometer, other products are also possible. For example, industrial equipment, or precision measuring instruments all may benefit from the foregoing described exemplary techniques with particle getters. Any stray particle large or small may damage the equipment or instruments that have mechanical components whose motion can be hindered. Therefore, the foregoing and similar embodiments may be applied to various applications, especially where there are cavities to contain or place particle contaminant getters.

Although specific embodiments have been illustrated and described above, it will be appreciated by those of ordinary skill in the art that any arrangement, which is calculated to achieve a same purpose, may be substituted for the specific embodiments shown. Therefore, it is manifestly intended that this invention be limited only by the claims and the equivalents thereof.

## Claims

1. A sensor device (100), the device comprising:
a sensor mechanism (110);
a structure (120) having an internal cavity (122) housing at least one passive element (114) of the sensor mechanism; and
a particle contaminant getter (126) within the cavity.

2. The device of claim 1, wherein the particle contaminant getter comprises a getter material coating cured to one or more surfaces (123) of the internal cavity.

3. The device of claim 2, wherein the getter material coating comprises an adhesive surface (127) exposed to an interior space of the internal cavity.

4. The device of claim 1,wherein the sensor mechanism further includes at least one active element (112) not located within the internal cavity, wherein the sensor device further comprises a path (124) between the internal cavity and the active element.

5. The device of claim 1, wherein one or both of a body and the passive element comprises a metal core magnetic circuit.

6. The device of claim 4, wherein the active element comprises one of a pair of capacitive plates and a mechanical mechanism.

7. The device of claim 1, wherein the particle contaminant getter comprises a preformed strip of getter material adhered to a surface within the inner cavity.

8. A method (500) for providing a particle contaminant getter for a device, the method comprising:
collecting particle contaminants within an internal cavity of a structure by distributing a liquid particle getter material onto one or more surfaces within the internal cavity (510); and
encasing the loose particle contaminants by curing the liquid particle getter material into a gel having an adhesive surface that faces into the internal cavity (520).

9. The method of claim 8, wherein distributing the liquid particle getter material onto one or more surfaces within the internal cavity further comprises:
spinning the structure.

10. The method of claim 8, further comprising:
forming a getter material coating on the one or more surfaces within the internal cavity by curing the liquid getter material.
